# EUROPEAN PATENT SPECIFICATION

(11) **EP 2 897 156 B1**
(45) Date of publication and mention of the grant of the patent: **18.10.2017**
(21) Application number: 15151662.2
(22) Date of filing: 19.01.2015
(51) Int. Cl.: H01J 37/32, C23C 16/455, H01L 21/3065

(54) **Plasma etching process**
Plasmaätzverfahren
Procédé de gravure par plasma

(30) Priority: 20.01.2014 JP 2014008113
(43) Date of publication of application: 22.07.2015
(73) Proprietor: TOKYO ELECTRON LIMITED, Minato-ku Tokyo 107-6325 (JP)
(72) Inventor: Amikura, Norihiko, Kurokawa-gun, Miyagi 981-3629 (JP); Sasaki, Norikazu, Kurokawa-gun, Miyagi 981-3629 (JP); Sawachi, Atsushi, Kurokawa-gun, Miyagi 981-3629 (JP)
(74) Representative: Manitz Finsterwald Patentanwälte PartmbB

(56) References cited:
- EP-A1- 2 492 955
- US-A1- 2004 235 191
- US-A1- 2005 241 763
- US-A1- 2006 021 703
- US-A1- 2010 323 501
- US-B1- 8 133 349

## Description

### TECHNICAL FIELD

The embodiments described herein pertain generally to a plasma etching process.

### BACKGROUND

Conventionally, there has been known a plasma processing apparatus that performs a desired plasma process to a semiconductor wafer as a target object by intermittently switching various processing gases.

Such a plasma processing apparatus includes, for example, a processing vessel in which a plasma process is performed to the semiconductor wafer; and a gas inlet member which is connected to switchable multiple gas supply lines and includes holes through which various processing gases respectively supplied from the multiple gas supply lines are introduced into the processing vessel. Further, in the plasma processing apparatus, electromagnetic energy such as microwaves, RF waves, etc., for exciting a processing gas within the processing vessel into plasma is supplied into the processing vessel. A processing gas supplied through the holes of the gas inlet member into a processing space within the processing vessel is excited into plasma by the electromagnetic energy, and a desired plasma process is performed to the semiconductor wafer by ions or radicals in the plasma.
Patent Document 1: Japanese Patent Laid-open Publication No. 2010-103358

Document US 2006 / 0 021703 A1 discloses a plasma processing apparatus including a processing vessel configured to perform therein a plasma etching process to a target substrate and a gas inlet member including first gas discharge holes and second gas discharge holes which are alternately arranged to be adjacent to each other and respectively communicate with a first gas supply line and a second gas supply line, which are switchable. Documents US 2004 / 0 235 191 A1 and US 2010 / 0 323 501 A1 relate to a film forming apparatus. Documents US 8 133 349 B1, US 2005 / 0 241763 A1 and EP 2 492 955 A1 disclose further conventional plasma processing apparatuses.

However, in the above-described conventional technology, it is difficult to switch the processing gases respectively supplied from the multiple gas supply lines into the processing vessel at a high speed in a uniform manner.

That is, in the conventional technology, through the holes of the gas inlet member, which commonly communicate with the switchable multiple gas supply lines, various processing gases respectively supplied from the multiple gas supply lines are introduced into the processing vessel. For this reason, in the conventional technology, after the gas supply lines are switched, it takes a preset time for a processing gas before switching to be completely discharged out from the holes of the gas inlet member by a processing gas after switching. As a result, in the conventional technology, switching of processing gases respectively supplied from the multiple gas supply lines into the processing vessel may be delayed.

Furthermore, in the conventional technology, during the preset time, the processing gas after switching and the processing gas before switching are mixed with each other, and the gas mixture is discharged from the holes of the gas inlet member. Thus, uniformity of the processing gases respectively supplied from the multiple gas supply lines into the processing vessel may be reduced.

### SUMMARY

The invention defines a plasma etching process to a target substrate in claim 1.

In accordance with the invention, it is possible to switch the processing gases respectively supplied from the multiple gas supply lines into the processing vessel at a high speed in a uniform manner.

The foregoing summary is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF THE DRAWINGS

In the detailed description that follows, embodiments, including embodiments of the invention, are described as illustrations only since various changes and modifications will become apparent to those skilled in the art from the following detailed description. The use of the same reference numbers in different figures indicates similar or identical items.
**FIG. 1** is a diagram schematically illustrating a configuration of a plasma processing apparatus in accordance with an example embodiment;
**FIG. 2** is a plane view of a shower head when viewed from a gas discharge hole in accordance with the example embodiment;
**FIG. 3** is a horizontal cross-sectional view passing through a first gas diffusion room of the shower head in accordance with the example embodiment;
**FIG. 4** is a horizontal cross-sectional view passing through a second gas diffusion room of the shower head in accordance with the example embodiment;
**FIG. 5A** to **FIG. 5G** are diagrams each schematically illustrating a cross section of a semiconductor wafer to be etched with plasma;
**FIG. 6** is a flow chart illustrating a process of a plasma etching method in accordance with the example embodiment;
**FIG. 7** is a plane view of a shower head from a gas discharge hole in accordance with another example embodiment;
**FIG. 8** is a horizontal cross-sectional view passing through a first gas diffusion room of the shower head in accordance with the another example embodiment; and
**FIG. 9** is a horizontal cross-sectional view passing through a second gas diffusion room of the shower head in accordance with the present example embodiment.

### DETAILED DESCRIPTION

In the following detailed description, reference is made to the accompanying drawings, which form a part of the description. In the drawings, similar symbols typically identify similar components, unless context dictates otherwise. Furthermore, unless otherwise noted, the description of each successive drawing may reference features from one or more of the previous drawings to provide clearer context and a more substantive explanation of the current example embodiment. Still, the example embodiments described in the detailed description, drawings, and claims are not meant to be limiting. Other embodiments may be utilized, and other changes may be made, without departing from the scope of the subject matter presented herein. It will be readily understood that the aspects of the present disclosure, as generally described herein and illustrated in the drawings, may be arranged, substituted, combined, separated, and designed in a wide variety of different configurations, all of which are explicitly contemplated herein.

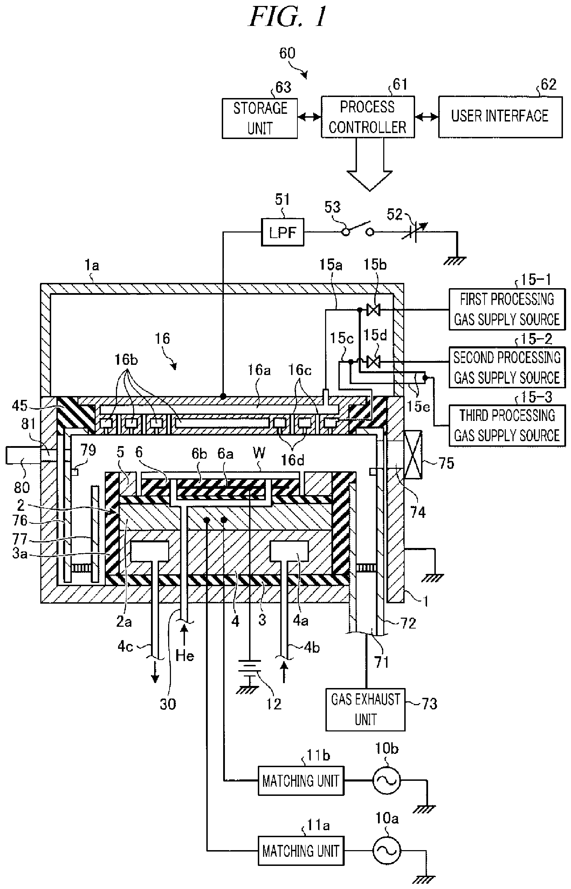

Hereinafter, an example embodiment will be explained in detail with reference to the accompanying drawings. **FIG. 1** is a diagram illustrating a configuration of a plasma processing apparatus in accordance with the present example embodiment. A configuration of a plasma processing apparatus will be explained first.

A plasma processing apparatus includes a processing chamber 1 which is airtightly provided and electrically grounded. The processing chamber 1 has a cylindrical shape, and is made of, *e.g*., aluminum having an anodically oxidized surface. The processing chamber 1 is one example of a processing vessel that performs a plasma process to a target substrate. Within the processing chamber 1, there is provided a mounting table 2 configured to horizontally mount a semiconductor wafer W as the target substrate thereon.

The mounting table 2 includes a base member 2a made of a conductive metal, *e.g*., aluminum, and serves as a lower electrode. The mounting table 2 is supported by a conductive supporting member 4 via an insulating plate 3. Further, a focus ring 5 formed of, *e.g*., single-crystalline silicon, is provided on an outer, peripheral portion of a top surface of the mounting table 2. Furthermore, a cylindrical inner wall member 3a made of, *e.g*., quartz or the like, is provided to surround the mounting table 2 and the supporting member 4.

The base member 2a of the mounting table 2 is connected to a first high frequency power supply 10a via a first matching unit 11a, and also connected to a second high frequency power supply 10b via a second matching unit 11b. The first high frequency power supply 10a is provided to generate plasma and configured to apply a high frequency power having a preset frequency (27 MHz or more, for example, 40 MHz) to the base member 2a of the mounting table 2. Further, the second high frequency power supply 10b is provided to attract (bias) ions and configured to apply a high frequency power having a preset frequency (13.56 MHz or less, *e.g*., 3.2 MHz) lower than that of the first high frequency power supply 10a to the base member 2a of the mounting table 2. Meanwhile, above the mounting table 2, a shower head 16 serving as an upper electrode is provided to face the mounting table 2 in parallel. The shower head 16 and the mounting table 2 serve as a pair of electrodes (upper electrode and lower electrode). The shower head 16 is supported on an upper portion of the processing chamber 1 via an insulating member 45.

Further, the shower head 16 includes multiple gas diffusion rooms and multiple gas discharge holes therein and is configured to discharge preset processing gases from the multiple gas diffusion rooms and the multiple gas discharge holes onto the semiconductor wafer W mounted on the mounting table 2. Furthermore, a configuration example of the shower head 16 will be explained later.

An electrostatic chuck 6 configured to electrostatically attract and hold the semiconductor wafer W is provided on an upper surface of the mounting table 2. The electrostatic chuck 6 includes insulators 6b and an electrode 6a embedded therebetween, and the electrode 6a is connected to a DC power supply 12. The semiconductor wafer W is attracted to and held on the electrostatic chuck 6 by a Coulomb force by applying a DC voltage from the DC power supply 12 to the electrode 6a.

A coolant path 4a is formed within the supporting member 4 and connected to a coolant inlet line 4b and a coolant outlet line 4c. By circulating a proper coolant, *e.g*., cooling water or the like, within the coolant path 4a, the supporting member 4 and the mounting table 2 can be controlled to have a preset temperature. Further, a backside gas supply line 30 configured to supply a cold heat transfer gas (backside gas) such as a helium gas or the like to a rear surface of the semiconductor wafer W is formed to penetrate through the mounting table 2 and the like, and connected to a non-illustrated back side gas supply source. With this configuration, the semiconductor wafer W attracted to and held on the upper surface of the mounting table 2 through the electrostatic chuck 6 can be controlled to have a preset temperature.

A variable DC power supply 52 is electrically connected to the shower head 16 serving as the upper electrode via a low pass filter (LPF) 51. Power supply of the variable DC power supply 52 can be on-off controlled by an on/off switch 53. The current and voltage applied from the variable DC power supply 52 and the on/off operation of the on/off switch 53 are controlled by a control unit 60 to be described later. As will be described later, when plasma is generated in a processing space by applying the high frequency powers from the first high frequency power supply 10a and the second high frequency power supply 10b to the mounting table 2, the on/off switch 53 is turned on by the control unit 60 if necessary, so that a preset DC voltage is applied to the shower head 16 serving as the upper electrode.

A cylindrical ground conductor 1a is provided and extended upwards from a sidewall of the processing chamber 1 to a height position higher than the shower head 16. The cylindrical ground conductor 1a has a ceiling wall at an upper portion thereof.

A gas exhaust opening 71 is formed at a bottom portion of the processing chamber 1, and a gas exhaust unit 73 is connected to the gas exhaust opening 71 through a gas exhaust line 72. The gas exhaust unit 73 includes a vacuum pump, and by operating the vacuum pump, the processing chamber 1 can be depressurized to a preset vacuum level. Further, a loading/unloading opening 74 for the wafer W is formed at a sidewall of the processing chamber 1, and a gate valve 75 configured to open and close the loading/unloading opening 74 is provided at the loading/unloading opening 74.

Reference numerals 76 and 77 denote detachable deposition shields. The deposition shield 76 is provided along an inner wall of the processing chamber 1 and serves to suppress etching by-products (deposits) from being attached to the inner wall of the processing chamber 1. At a height position of the deposition shield 76 to be substantially equal to that of the semiconductor wafer W, there is provided a conductive member (GND block) 79 connected to the ground in a DC manner and configured to suppress abnormal electric discharge.

The overall operations of the plasma processing apparatus having the above-described configuration are controlled by the control unit 60. The control unit 60 includes a process controller 61 including a CPU to control various units of the plasma processing apparatus, a user interface 62, and a storage unit 63.

The user interface 62 includes a keyboard configured to input commands to allow a process manager to manage the plasma processing apparatus, a display unit configured to display an operation status of the plasma processing apparatus.

The storage unit 63 is configured to store therein recipes including control programs (software) for implementing various processes performed in the plasma processing apparatus under the control of the process controller 61, or recipes that store processing condition data. If necessary, a required process is performed in the plasma processing apparatus under the control of the process controller 61 by retrieving a preset recipe from the storage unit 63 in response to an instruction from the user interface 62 and executing the recipe by the process controller 61. Further, the control program or the recipe of the processing condition data may be stored in a computer-readable computer storage medium (for example, a hard disk, a CD, a flexible disk, a semiconductor memory, or the like). Otherwise, the control program or the recipe may also be frequently transmitted on-line from another apparatus via, *e.g*., a dedicated line.

Further, an endpoint detector (EPD) 80 is provided at a sidewall portion of the processing chamber 1, and configured to detect a change in plasma emission intensity in the processing space within the processing chamber 1 via a window 81 arranged at the sidewall portion of the processing chamber 1 to detect an endpoint of an etching process.

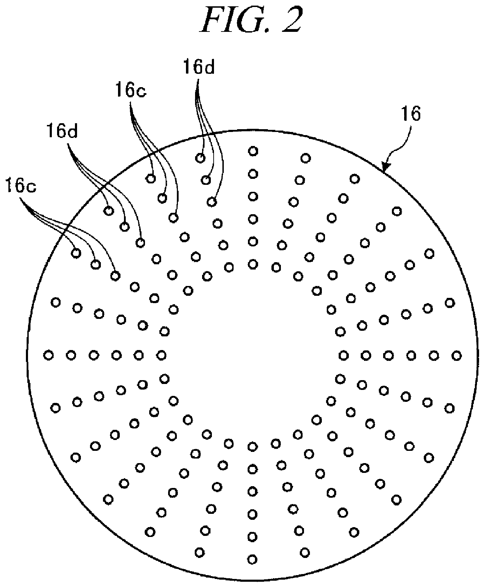

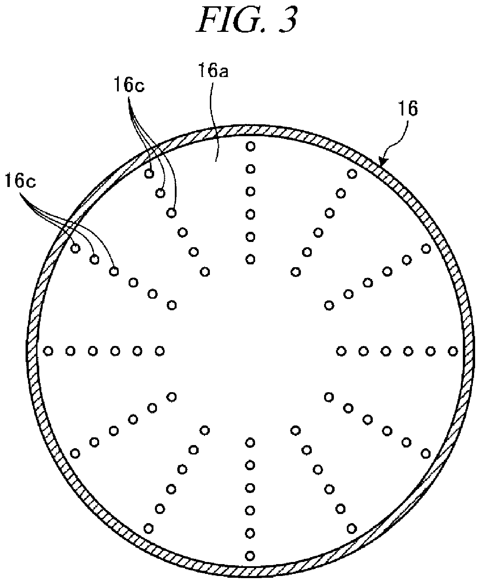

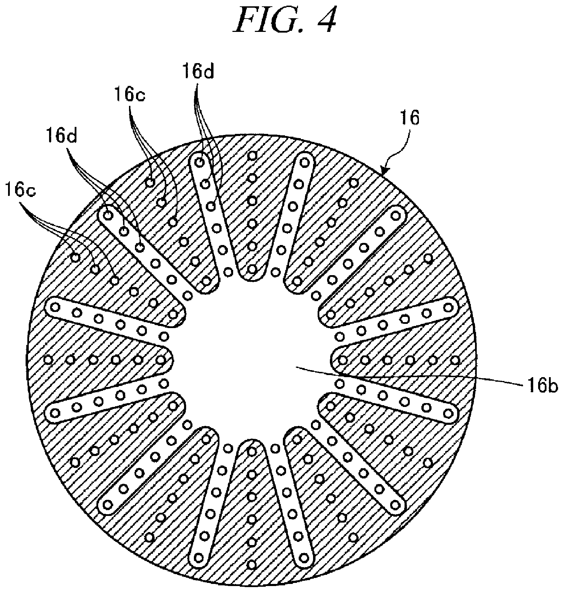

Hereinafter, referring to **FIG. 1** to **FIG. 4****,** a configuration example of the shower head 16 illustrated in **FIG. 1** will be explained. **FIG. 2** is a plane view of the shower head when viewed from a gas discharge hole in accordance with the example embodiment. **FIG. 3** is a horizontal cross-sectional view passing through a first gas diffusion room of the shower head in accordance with the example embodiment. **FIG. 4** is a horizontal cross-sectional view passing through a second gas diffusion room of the shower head in accordance with the example embodiment.

As depicted in **FIG. 1** and **FIG. 2****,** the shower head 16 has a disc shape. The shower head 16 includes therein a first gas diffusion room 16a, a second gas diffusion room 16b, first gas discharge holes 16c extended from the first gas diffusion room 16a, and second gas discharge holes 16d extended from the second gas diffusion room 16b.

The first gas diffusion room 16a is connected to one end of a first gas supply line 15a and configured to diffuse a first processing gas supplied from the first gas supply line 15a. The first gas diffusion room 16a is one example of a first gas diffusion region. The other end of the first gas supply line 15a is connected to a first processing gas supply source 15-1 configured to supply the first processing gas. An opening/closing valve 15b configured to open and close the first gas supply line 15a is provided at the first gas supply line 15a.

As depicted in **FIG. 1** and **FIG. 3****,** the first gas discharge holes 16c are extended from the first gas diffusion room 16a, and communicate with the first gas supply line 15a via the first gas diffusion room 16a. The first gas, discharge holes 16c introduce the first processing gas supplied from the first gas supply line 15a into the processing chamber 1 through the first gas diffusion room 16a.

The second gas diffusion room 16b is connected to one end of a second gas supply line 15c and configured to diffuse a second processing gas supplied from the second gas supply line 15c. The second gas diffusion room 16b is one example of a second gas diffusion region. The other end of the second gas supply line 15c is connected to a second processing gas supply source 15-2 configured to supply the second processing gas. An opening/closing valve 15d configured to open and close the second gas supply line 15c is provided at the second gas supply line 15c.

As depicted in **FIG. 1** and **FIG. 4****,** the second gas discharge holes 16d are extended from the second gas diffusion room 16b, and communicate with the second gas supply line 15c via the second gas diffusion room 16b. The second gas discharge holes 16d introduce the second processing gas supplied from the second gas supply line 15c into the processing chamber 1 through the second gas diffusion room 16b.

The first gas discharge holes 16c and the second gas discharge holes 16d are alternately arranged to be adjacent to each other. To be specific, as depicted in **FIG. 2****,** the first gas discharge holes 16c and the second gas discharge holes 16d are alternately arranged to be adjacent to each other along a circumference of the shower head 16.

Further, as depicted in **FIG. 1** and **FIG. 4****,** the first gas diffusion room 16a and the second gas diffusion room 16b are vertically overlapped with each other, and the second gas diffusion room 16b is formed at a region where the first gas discharge holes 16c extended from the first gas diffusion room 16a are not arranged. In other words, a part of the second gas diffusion room 16b is extended to a space interposed between the adjacent first gas discharge holes 16c arranged along the circumference of the shower head 16.

Furthermore, the first gas supply line 15a and the second gas supply line 15c are intermittently switched by the opening/closing valve 15b and the opening/closing valve 15d, respectively. That is, if the opening/closing valve 15b is opened and the opening/closing valve 15d is closed, the first processing gas is supplied from the first gas supply line 15a into the first gas diffusion room 16a. Then, the first processing gas supplied into the first gas diffusion room 16a is discharged into the processing chamber 1 through the first gas discharge holes 16c extended from the first gas diffusion room 16a. On the other hand, if the opening/closing valve 15b is closed and the opening/closing valve 15d is opened, the second processing gas is supplied from the second gas supply line 15c into the second gas diffusion room 16b. Then, the second processing gas supplied into the second gas diffusion room 16b is discharged into the processing chamber 1 through the second gas discharge holes 16d extended from the second gas diffusion room 16b. Further, the operations of the opening/closing valve 15b and the opening/closing valve 15d are controlled by the control unit 60.

Desirably, the first gas supply line 15a and the second gas supply line 15c may be switched at a preset cycle of, for example, 200 msec or more to 500 msec or less, in order to improve various etching characteristics.

As described above, in the present example embodiment, the switchable first and second gas supply lines 15a and 15c are configured to respectively communicate with the first and second gas discharge holes 16c and 16d of the shower head 16, and the first and second gas discharge holes 16c and 16d are alternately arranged to be adjacent to each other the circumference of the shower head 16. For this reason, in accordance with the present example embodiment, it is possible to independently supply the first and second processing gases respectively supplied from the first and second gas supply lines 15a and 15c into the processing chamber 1. Therefore, even if the first and second gas supply lines 15a and 15c are switched, it is possible to suppress a processing gas before switching from being mixed with a processing gas after switching. As a result, in accordance with the present example embodiment, as compared with the conventional technology in which the holes of the gas inlet member commonly communicate with the switchable multiple gas supply lines, it is possible to switch the processing gases respectively supplied from the multiple gas supply lines into the processing vessel at a high speed in a uniform manner.

As depicted in **FIG. 1****,** the first gas supply line 15a and the second gas supply line 15c are respectively connected to a third gas supply line 15e branched from a line extended from a third processing gas supply source 15-3 configured to supply a third processing gas. The third gas supply line 15e supplies the third processing gas supplied from the third processing gas supply source 15-3 to both of the first gas supply line 15a and the second gas supply line 15c. The first gas supply line 15a and the second gas supply line 15c may be switched, if necessary, in a state where the third processing gas is supplied to both of the first gas supply line 15a and the second gas supply line 15c.

Hereinafter, there will be explained a sequence for plasma-etching a silicon dioxide layer formed on the semiconductor wafer W in the plasma processing apparatus configured as described above. The gate valve 75 is first opened, and the semiconductor wafer W is loaded by a non-illustrated transfer robot into the processing chamber 1 through the loading/unloading opening 74 via a non-illustrated load-lock chamber, and then, mounted on the mounting table 2. Then, the transfer robot is retreated to the outside of the processing chamber 1, and the gate valve 75 is closed. Thereafter, the inside of the processing chamber 1 is exhausted through the gas exhaust opening 71 by the vacuum pump of the gas exhaust unit 73.

After the inside of the processing chamber 1 is exhausted to a preset vacuum level, the first processing gas supplied from the first processing gas supply source 15-1 and the second processing gas supplied from the second processing gas supply source 15-2 are alternately introduced into the processing chamber 1, and the inside of the processing chamber 1 is maintained at a preset pressure. In this case, the third processing gas may be supplied from the third processing gas supply source 15-3 as necessary.

Further, in this state, a high frequency power having a frequency of, for example, 40 MHz for plasma generation is supplied from the first high frequency power supply 10a to the mounting table 2. Furthermore, a high frequency (bias) power having a frequency of, for example, 3.2 MHz for ion attraction is supplied from the second high frequency power supply 10b to the base member 2a of the mounting table 2. In this case, a preset DC voltage is applied from the DC power supply 12 to the electrode 6a of the electrostatic chuck 6, and the semiconductor wafer W is attracted to and held on the electrostatic chuck 6 by a Coulomb force.

As described above, by applying the high frequency powers to the mounting table 2 as the lower electrode, an electric field is formed between the upper electrode, *i.e.,* the shower head 16 and the lower electrode, *i.e.,* the mounting table 2. An electric discharge is generated by the electric field in the processing space where the semiconductor wafer W is provided. As a result, plasma of the processing gas is generated, and a silicon dioxide layer or the like formed on the semiconductor wafer W is etched by the plasma of the processing gas.

Further, as described above, since a DC voltage can be applied to the shower head 16 during the plasma process, the following effects can be obtained. That is, plasma having the high electron density and the low ion energy may be required depending on processes. In such a case, by applying the DC voltage, it is possible to decrease the ion energy into the semiconductor wafer W and to increase the electron density of the plasma. As a consequence, an etching rate of an etching target film on the semiconductor wafer W is increased, whereas a sputtering rate of a film serving as a mask formed on the etching target film is reduced. As a result, the selectivity can be improved.

Upon the completion of the above-described etching process, the supplies of the high frequency powers, the DC voltage and the processing gases are stopped, and the semiconductor wafer W is unloaded from the processing chamber 1 in the reverse order to the above-described order.

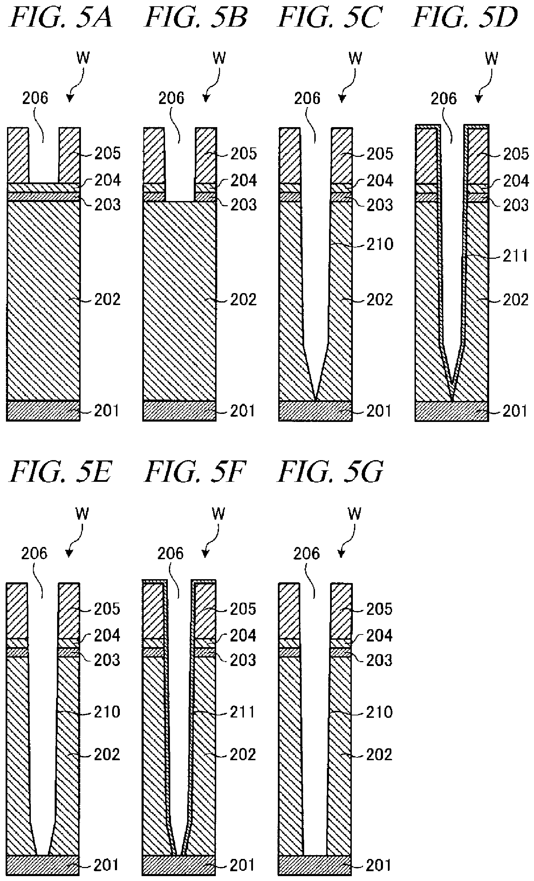

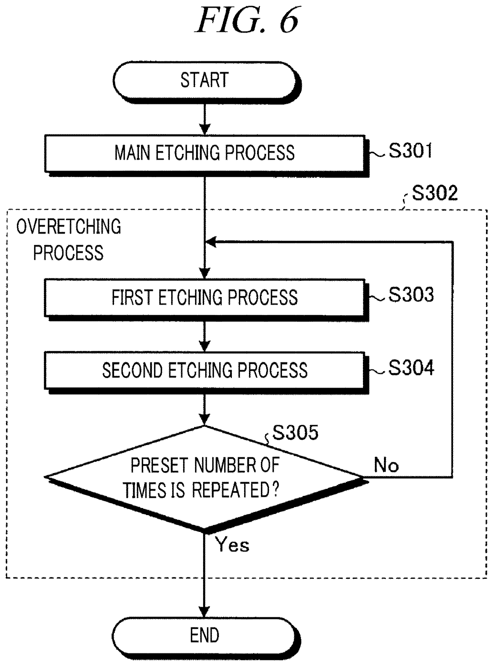

Hereinafter, a plasma etching method performed in the plasma processing apparatus in accordance with the present example embodiment will be described in a case of forming a contact hole having a high aspect ratio with reference to **FIG. 5A** to **FIG. 6****.** **FIG. 5A** to **FIG. 5G** are diagrams each schematically illustrating a cross section of the semiconductor wafer to be etched with plasma, and **FIG. 6** is a flow chart illustrating a plasma etching process.

As shown in **FIG. 5A****,** in the semiconductor wafer W, a silicon dioxide layer 202 (having a thickness of 2000 nm) is formed on a silicon nitride layer 201 (having a thickness of 30 nm) as an etching stop layer. On the silicon dioxide layer 202 (having the thickness of 2000 nm), a silicon nitride layer 203 (having a thickness of 100 nm), a silicon dioxide layer 204 (having a thickness of 100 nm) and a polysilicon layer 205 (having a thickness of 500 nm) serving as a mask layer are formed. A top opening diameter (Top CD) and a bottom opening diameter (Bottom CD) of an opening 206 formed in the polysilicon layer 205 are set to be 39 nm and 30 nm, respectively. A gap between adjacent openings 206 is set to be 40 nm.

From the above-described state, the silicon dioxide layer 204 and the silicon nitride layer 203 are etched in sequence, so that a state shown in **FIG. 5B** is obtained. Then, an etching process, in which a hole 210 having a high aspect ratio is formed by etching the silicon dioxide layer 202, is performed. This etching process includes two processes: a main etching process (process S301 (Main Etching Process) of **FIG. 6****)** in which the silicon dioxide layer 202 is etched up to the vicinity of the bottom thereof; and an etching process (hereinafter, referred to "overetching process") (process S302 (Overetching Process) of **FIG. 6****)** performed immediately before or after the silicon nitride layer 201 in the vicinity of the bottom of the silicon dioxide layer 202 is exposed.

The main etching process is performed to etch the silicon dioxide layer 202 up to the vicinity of the bottom thereof, so that a state shown in **FIG. 5C** is obtained. Then, the overetching process is performed. In this overetching process, a first etching process (process S303 (First Etching Process) of **FIG. 6****)** and a second etching process (process S304 (Second Etching Process) of **FIG. 6****)** are alternately repeated a preset number of times (process S305 (whether Preset Number of Times is repeated) of **FIG. 6**). In the first etching process, a gaseous mixture of a C₄F₆ gas, an Ar gas, and an O₂ gas is used as a processing gas. Further, in the second etching process, a gaseous mixture of a C₄F₈ gas, an Ar gas, and an O₂ gas or a gaseous mixture of a C₃F₈ gas, an Ar gas, and an O₂ gas is used as a processing gas.

The first etching process will be described with reference to a more specific example. The control unit 60 of the plasma processing apparatus introduces a C₄F₆ gas as the first processing gas into the processing chamber 1 from the first gas supply line 15a through the first gas diffusion room 16a and the first gas discharge holes 16c by opening the opening/closing valve 15b and closing the opening/closing valve 15d. Then, the control unit 60 applies the high frequency power for plasma generation into the processing chamber 1 from the first high frequency power supply 10a to generate plasma from the C₄F₆ gas. At the same time, the control unit 60 applies the high frequency power for ion attraction to the base member 2a of the mounting table 2 from the second high frequency power supply 10b to attract ions in the plasma toward the semiconductor wafer W.

The second etching process will be described with reference to a more specific example. The control unit 60 of the plasma processing apparatus introduces a C₄F₈ gas or a C₃F₈ gas as the second processing gas into the processing chamber 1 from the second gas supply line 15c through the second gas diffusion room 16b and the second gas discharge holes 16d by closing the opening/closing valve 15b and opening the opening/closing valve 15d. Then, the control unit 60 applies the high frequency power for plasma generation into the processing chamber 1 from the first high frequency power supply 10a to generate plasma from the C₄F₈ gas or the C₃F₈ gas. At the same time, the control unit 60 applies the high frequency power for ion attraction to the base member 2a of the mounting table 2 from the second high frequency power supply 10b to attract ions in the plasma toward the semiconductor wafer W.

Further, if the first and second gas supply lines 15a and 15c are switched in the first etching process and the second etching process, *i.e.,* the opening and the closing of the opening/closing valve 15b and the opening/closing valve 15d are switched, the control unit 60 performs the following process. That is, the control unit 60 switches the opening and the closing of the opening/closing valve 15b and the opening/closing valve 15d in a state where an Ar gas and an O₂ gas as the third processing gas are supplied from the third gas supply line 15e to both of the first and second gas supply lines 15a and 15c.

Under an etching condition of the first etching process, a great amount of deposits are generated, and a protection film 211 is formed on the hole 210, as shown in **FIG. 5D****.** Meanwhile, under an etching condition of the second etching process, a small amount of deposits are generated, and the protection film 211 formed on the hole 210 is etched to be removed and a bottom portion of the hole 210 is etched, as shown in **FIG. 5E****.** As shown in **FIG. 5E****,** after the protection film 211 formed on the hole 210 is removed by the etching process, the first etching process is performed again, so that a protection film 211 is formed on the hole 210, as depicted in **FIG. 5F****.**

After repeatedly performing the first etching process and the second etching process multiple times as such, the second etching process is finally performed, so that a hole 210 having a high aspect ratio and reaching the silicon nitride layer 201 as the etching stop layer is formed as depicted in **FIG. 5G****.**

In the overetching process, it is possible to set a time period, during which each of the first etching process and the second etching process is performed one time, to be small value in order to control the status of the protection film 211 more precisely. However, it takes about a few seconds to switch almost all of the gas within the processing chamber 1. For this reason, switching of the first and second gas supply lines 15a and 15c, *i.e.,* switching the opening and the closing of the opening/closing valve 15b and the opening/closing valve 15d, may be performed at a cycle of desirably 200 msec or more to 500 msec or less.

As described above, in accordance with the present example embodiment, the switchable first and second gas supply lines 15a and 15c are configured to respectively and independently communicate with the first and second gas discharge holes 16c and 16d of the shower head 16, and the first and second gas discharge holes 16c and 16d are alternately arranged to be adjacent to each other. For this reason, in accordance with the present example embodiment, it is possible to independently introduce the first and second processing gases respectively supplied from the first and second gas supply lines 15a and 15c into the processing chamber 1. Therefore, even if the first and second gas supply lines 15a and 15c are switched, it is possible to suppress a processing gas before switching from being mixed with a processing gas after switching. As a result, in accordance with the present example embodiment, as compared with the conventional technology in which the holes of the gas inlet member commonly communicate with the switchable multiple gas supply lines, it is possible to switch processing gases respectively supplied from the multiple gas supply lines into the processing vessel at a high speed in a uniform manner.

Further, in the present example embodiment, the shower head 16 includes the first and second gas diffusion rooms 16a and 16b vertically overlapped with each other, and the second gas diffusion room 16b is formed at a region where the first gas discharge holes 16c extended from the first gas diffusion room 16a are not arranged. For this reason, in accordance with the present example embodiment, if the first and second gas supply lines 15a and 15c are switched, the first and second gas diffusion rooms 16a and 16b are switched and the first and second processing gases can be rapidly introduced into the processing chamber 1 in an independent manner from each other. As a result, in accordance with the present example embodiment, it is possible to switch processing gases respectively supplied from multiple gas supply lines into the processing vessel at a higher speed.

Furthermore, in the present example embodiment, the first and second gas discharge holes 16c and 16d of the shower head 16 are alternately arranged to be adjacent to each other along the circumference of the shower head 16. As a result, in accordance with the present example embodiment, even if the processing gases respectively supplied from multiple gas supply lines into the processing vessel are switched, a processing gas after switching can be supplied into the processing vessel in a uniform manner along the circumference of the shower head 16.

Moreover, in the present example embodiment, the first and second gas supply lines 15a and 15c are switched at the cycle of 200 msec or more to 500 msec or less. As a result, in accordance with the present example embodiment, a time period from when the processing gases respectively supplied from multiple gas supply lines into the processing vessel are switched to when the processing gas within the processing vessel is completely switched can be shortened.

Further, in the present example embodiment, the first and second gas supply lines 15a and 15c are switched in the state where the third processing gas different from the first and second processing gases is supplied to both of the first and second gas supply lines 15a and 15c. As a result, the processing gases respectively supplied from multiple gas supply lines into the processing vessel can be switched at a high speed in a uniform manner while continuously supplying an inert gas, which does not need to be switched, as the third processing gas into the processing vessel.

### (Another example embodiment)

The plasma processing apparatus in accordance with the example embodiment has been explained above, but the present disclosure is not limited thereto. Hereinafter, another example embodiment will be explained.

By way of example, in the plasma processing apparatus in accordance with the above-described example embodiment, the first and second gas discharge holes 16c and 16d of the shower head 16 are alternately arranged to be adjacent to each other along the circumference of the shower head 16, but the present disclosure is not limited thereto. By way of example, the first and second gas discharge holes 16c and 16d of the shower head 16 may be alternately arranged to be adjacent to each other along a diameter of the shower head 16. Hereinafter, a configuration example of the shower head 16 in accordance with the another example embodiment will be explained. Further, components identical or similar to those explained in the above-described example embodiment will be assigned identical reference numerals, and explanation thereof will be omitted.

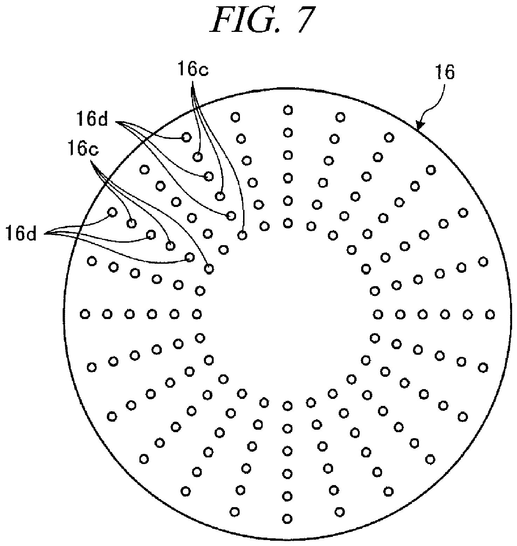

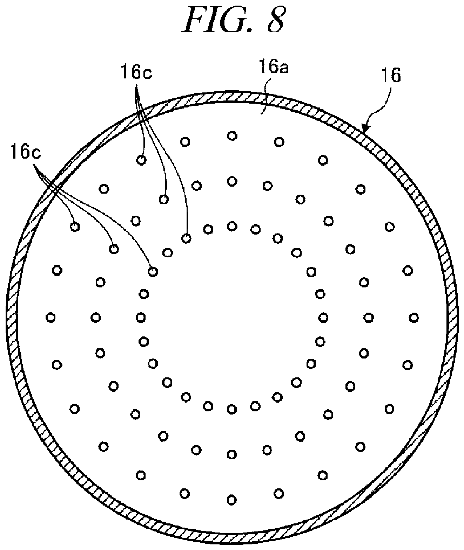

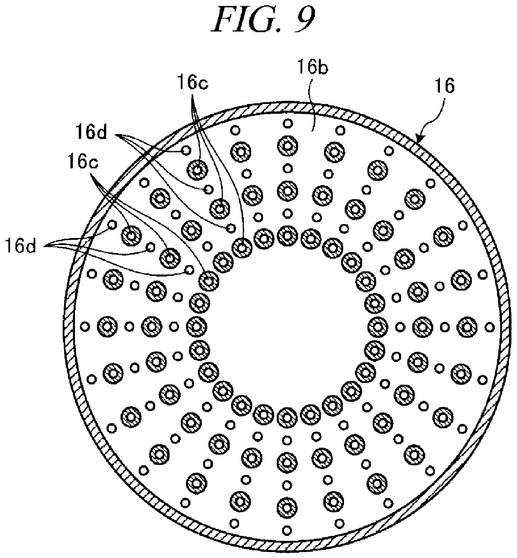

FIG. 7 is a plane view of a shower head from a gas discharge hole in accordance with another example embodiment. **FIG. 8** is a horizontal cross-sectional view passing through a first gas diffusion room of the shower head in accordance with the another example embodiment. **FIG. 9** is a horizontal cross-sectional view passing through a second gas diffusion room of the shower head in accordance with the present example embodiment.

The shower head 16 of the another example embodiment has a disc shape in the same manner as the shower head 16 illustrated in **FIG. 1****.** The shower head 16 includes therein the first gas diffusion room 16a, the second gas diffusion room 16b, the first gas discharge holes 16c extended from the first gas diffusion room 16a, and the second gas discharge holes 16d extended from the second gas diffusion room 16b in the same manner as the shower head 16 illustrated in **FIG. 1****.**

The first gas discharge holes 16c and the second gas discharge holes 16d are alternately arranged to be adjacent to each other along the diameter of the shower head 16 as depicted in **FIG. 7****.**

Further, the first gas diffusion room 16a and the second gas diffusion room 16b are vertically overlapped with each other in the same manner as the shower head 16 illustrated in **FIG. 1****.** The second gas diffusion room 16b is formed at a region where the first gas discharge holes 16c extended from the first gas diffusion room 16a are not arranged, as depicted in **FIG. 8** and **FIG. 9****.** In other words, the second gas diffusion room 16b is formed to avoid column-shaped regions covering the first gas discharge holes 16c arranged along the diameter of the shower head 16.

As described above, in the another example embodiment, the first and second gas discharge holes 16c and 16d of the shower head 16 are alternately arranged to be adjacent to each other along the diameter of the shower head 16. As a result, in accordance with the present example embodiment, even if the processing gases respectively supplied from multiple gas supply lines into the processing vessel are switched, a processing gas after switching can be supplied into the processing vessel in a uniform manner along the diameter of the shower head 16.

From the foregoing, it will be appreciated that various embodiments of the present disclosure have been described herein for purposes of illustration, and that various modifications may be made without departing from the scope of the present disclosure. Accordingly, the various embodiments disclosed herein are not intended to be limiting, with the true scope being indicated by the following claim.

## Claims

1. A plasma etching process to a target substrate (W) performed in a processing vessel (1) of a plasma processing apparatus, wherein the plasma processing apparatus comprises:
a gas inlet member (16) including first gas discharge holes (16c) and second gas discharge holes (16d) which are alternately arranged to be adjacent to each other and respectively communicate with a first gas supply line (15a) and a second gas supply line (15c), which are switchable, wherein the first gas supply line (15a) and the second gas supply line (15c) are respectively connected to a third gas supply line (15e); and
a control unit (60),
wherein the control unit (60) intermittently switches the first gas supply line (15a) and the second gas supply line (15c), wherein the first gas discharge holes (16c) and the second gas discharge holes (16d) independently and respectively introduce a first processing gas including a C₄F₆ gas and a second processing gas including a C₄F₈ gas or a C₃F₈ gas, which are respectively supplied from the first gas supply line (15a) and the second gas supply line (15c) and used in the plasma etching process, into the processing vessel (1), and wherein the control unit (60) switches the first gas supply line (15a) and the second gas supply line (15c) in a state where a third processing gas different from the first processing gas and the second processing gas is supplied from the third gas supply line (15e) to both of the first gas supply line (15a) and the second gas supply line (15c).

## Patentansprüche

1. Plasmaätzverfahren an einem Zielsubstrat (W), das in einem Prozessbehälter (1) einer Plasmaverarbeitungsvorrichtung durchgeführt wird, wobei die Plasmaverarbeitungsvorrichtung umfasst:
ein Gaseinlasselement (16), das erste Gasaustragslöcher (16c) und zweite Gasaustragslöcher (16d) umfasst, die abwechselnd derart angeordnet sind, dass sie benachbart zueinander liegen und jeweils mit einer ersten Gaszufuhrleitung (15a) und einer zweiten Gaszufuhrleitung (15c) kommunizieren, welche umschaltbar sind, wobei die erste Gaszufuhrleitung (15a) und die zweite Gaszufuhrleitung (15c) jeweils mit einer dritten Gaszufuhrleitung (15e) verbunden sind; und
eine Steuereinheit (60);
wobei die Steuereinheit (60) die erste Gaszufuhrleitung (15a) und die zweite Gaszufuhrleitung (15c) intermittierend umschaltet;
wobei
die ersten Gasaustragslöcher (16c) und die zweiten Gasaustragslöcher (16d) unabhängig und jeweils ein erstes Prozessgas, das ein C₄F₆-Gas umfasst, und ein zweites Prozessgas, das ein C₄F₈-Gas oder ein C₃F₈-Gas umfasst, die jeweils von der ersten Gaszufuhrleitung (15a) und der zweiten Gaszufuhrleitung (15c) zugeführt und in dem Plasmaätzverfahren verwendet werden, in den Prozessbehälter (1) einleiten,
und wobei
die Steuereinheit (60) die erste Gaszufuhrleitung (15a) und die zweite Gaszufuhrleitung (15c) in einen Zustand umschaltet, in welchem ein drittes Prozessgas, das sich von dem ersten Prozessgas und dem zweiten Prozessgas unterscheidet, von der dritten Gaszufuhrleitung (15e) sowohl der ersten Gaszufuhrleitung (15a) als auch der zweiten Gaszufuhrleitung (15c) zugeführt wird.

## Revendications

1. Procédé de gravure par plasma sur un substrat cible (W) exécuté dans une enceinte de traitement (1) d'un appareil de traitement par plasma, dans lequel l'appareil de traitement par plasma comprend :
un élément d'entrée de gaz (16) incluant des premiers trous de décharge de gaz (16c) et des seconds trous de décharge de gaz (16d) qui sont agencés alternativement pour être adjacents les uns aux autres et qui communiquent respectivement avec un premier conduit d'alimentation de gaz (15a) et un second conduit d'alimentation de gaz (15c), qui sont susceptibles d'être commutés, dans lequel le premier conduit d'alimentation de gaz (15a) et le second conduit d'alimentation de gaz (15c) sont connectés respectivement à un troisième conduit d'alimentation de gaz (15e) ; et
une unité de commande (60),
dans lequel l'unité de commande (60) commute de façon intermittente le premier conduit d'alimentation de gaz (15a) et le second conduit d'alimentation de gaz (15c),
dans lequel les premiers trous de décharge de gaz (16c) et les seconds trous de décharge de gaz (16d) introduisent indépendamment et respectivement un premier gaz de traitement incluant un gaz C₄F₆ et un second gaz de traitement incluant un gaz C₄F₈ ou un gaz C₃F₈, qui sont respectivement alimentés depuis le premier conduit d'alimentation de gaz (15a) et le second conduit d'alimentation de gaz (15c) et qui sont utilisés dans le traitement de gravure par plasma, jusque dans l'enceinte de traitement (1),
et dans lequel l'unité de commande (60) commute le premier conduit d'alimentation de gaz (15a) et le second conduit d'alimentation de gaz (15c) dans un état dans lequel un troisième gaz de traitement différent du premier gaz de traitement et du second gaz de traitement est alimenté depuis le troisième conduit d'alimentation de gaz (15e) à la fois au premier conduit d'alimentation de gaz (15a) et au second conduit d'alimentation de gaz (15c).
